# FASCICULE DE BREVET EUROPEEN

(11) **EP 0 490 728 B1**
(45) Date de publication et mention de la délivrance du brevet: **03.01.1996**
(21) Numéro de dépôt: 91403246.1
(22) Date de dépôt: 29.11.1991
(51) Int. Cl.: G01R 31/02, G01R 1/067

(54) **Système pour tester la continuité électrique et l'isolement des conducteurs électriques d'une pièce de câblage**
Einrichtung zum Testen des elektrischen Durchgangs und der Isolierung elektrischer Leiter einer Verkabelung
Device for testing electric continuity and insulation of electric conductors of a wiring

(30) Priorité: 10.12.1990 FR 9015431
(43) Date de publication de la demande: 17.06.1992
(73) Titulaire: EUROCOPTER FRANCE, F-13725 Marignane Cédex (FR)
(72) Inventeur: Cerda, Léon Germain, F-13620 Carry-le-Rouet (FR)
(74) Mandataire: Bonnetat, Christian

(56) Documents cités:
- EP-A- 0 225 682
- EP-A- 0 383 653
- WO-A-85/04488
- FR-A- 1 593 025
- FR-A- 2 483 159
- US-A- 4 471 298

## Description

La présente invention concerne un système pour tester la continuité électrique et l'isolement des conducteurs électriques d'une pièce de câblage. Par le terme "pièce de câblage", on désigne un faisceau de conducteurs, c'est-à-dire de fils électriques ou câbles, permettant la transmission des informations et des commandes nécessaires pour le fonctionnement d'une machine complexe, notamment un aéronef.

De façon connue, pour vérifier la continuité électrique et l'isolement des conducteurs d'une pièce de câblage, après l'achèvement de sa fabrication en atelier et avant son montage par exemple à bord d'un aéronef, tel qu'un hélicoptère, on utilise un banc de tests spécialisé sur lequel on branche tous les conducteurs de ladite pièce de câblage.

On sait qu'un tel système pour tester la continuité électrique et l'isolement des conducteurs électriques d'une pièce de câblage, munis chacun de premier et second éléments de connexion, comporte :
- des moyens de liaison avec lesdits premier et second éléments de connexion de chacun desdits conducteurs, lesdits moyens de liaison comprenant une pluralité d'organes de branchement, aux entrées desquels sont aptes à être branchés les premier et second éléments de connexion de chacun desdits conducteurs ;
- des moyens de mesure d'une grandeur électrique, reliés à des sorties déterminées desdits organes de branchement par l'intermédiaire de moyens de sélection desdites sorties pour, d'une part, relier les premier et second éléments de connexion du conducteur testé auxdits moyens de mesure, de façon à tester la continuité électrique dudit conducteur et, d'autre part, relier ledit conducteur testé à au moins certains autres conducteurs de la pièce de câblage, de façon à tester l'isolement dudit conducteur par rapport auxdits autres conducteurs ;
- des moyens générateurs d'une grandeur électrique identique à celle mesurée ou différente de cette dernière ; et
- des moyens de pilotage du système et d'analyse des tests.

Dans les bancs de tests usuels, les moyens de sélection des sorties des organes de branchement sont constitués par des ensembles de commutateurs ou interrupteurs, et des commandes desdits interrupteurs. Ainsi, pour un banc de tests qui peut comporter plusieurs milliers de points de tests, il est nécessaire de prévoir autant d'interrupteurs, et, même en utilisant des artifices pour regrouper lesdits interrupteurs, le nombre des commandes de ces derniers reste très élevé. Par ailleurs, les nécessités de tenue en tension et de maintenance, notamment, obligent d'utiliser des interrupteurs spécifiques, connus sous le nom d'interrupteurs à lames souples. Ceux-ci sont constitués de deux lames en matériau magnétique, séparées par un entrefer et enfermées dans une ampoule de verre sous atmosphère inerte ou sous vide. Pour des raisons de tenue en tension, la masse de matériau magnétique et l'entrefer entre les lames doivent être relativement importants, de sorte que l'encombrement d'un tel interrupteur n'est pas négligeable. De ce fait, le volume et le poids d'un banc de tests usuel sont considérables. Par exemple, le volume d'un banc de tests de 8400 points, couramment utilisé actuellement, est d'environ 4 m³, et son poids de 600 à 700 kg, ce qui, bien entendu, nuit fortement à sa mobilité et à sa souplesse d'emploi. Par ailleurs, le nombre élevé de commandes (174 commandes pour un banc de tests de 8400 points) entraîne une grande complexité des moyens de pilotage, avec les risques de pannes et le manque de fiabilité que cela implique.

La présente invention a pour but d'éviter ces inconvénients, et concerne un système pour tester la continuité électrique et l'isolement des conducteurs d'une pièce de câblage, dont le volume, le poids et la consommation d'énergie électrique sont remarquablement réduits par rapport aux systèmes usuels, et qui présente une plus grande fiabilité.

A cet effet, le système pour tester la continuité électrique et l'isolement des conducteurs d'une pièce de câblage, du type décrit ci-dessus, est remarquable, selon l'invention, en ce que les sorties desdits organes de branchement sont agencées, sur un support, sous forme d'une matrice de n lignes et p colonnes, et en ce que lesdits moyens de sélection comprennent, d'une part pour le test de continuité, des premier et deuxième équipages, susceptibles de se déplacer le long des lignes et colonnes de ladite matrice, pour relier auxdits moyens de mesure les deux sorties desdits organes de branchement, correspondant aux premier et second éléments de connexion du conducteur testé, et d'autre part pour le test d'isolement, un troisième équipage, susceptible de se déplacer le long des lignes et colonnes de ladite matrice, pour relier auxdits moyens de mesure une sortie desdits organes de branchement, correspondant à un élément de connexion du conducteur testé, et un quatrième équipage pour relier au moins certaines autres sorties desdits organes de branchement auxdits moyens de mesure.

Ainsi, le système de la présente invention tire parti de la haute précision obtenue, à l'heure actuelle, dans les déplacements de pièces mécaniques (en l'occurence lesdits équipages), et des progrès de la micromécanique, pour simplifier les fonctions électriques impliquées dans les systèmes usuels. En particulier, l'agencement du système de l'invention permet de s'affranchir de la multiplicité d'interrupteurs et de commandes utilisés jusqu'à présent, en diminuant considérablement le volume et le poids du système ainsi que sa consommation d'énergie électrique, tout en le rendant plus fiable.

Avantageusement, lesdits premier, deuxième, troisième et quatrième équipages sont associés, chacun, à une matrice de n lignes et p colonnes desdites sorties desdits organes de branchement, les sorties correspondantes desdites matrices étant reliées en parallèle, et lesdits premier, deuxième et troisième équipages comprennent, chacun, un mécanisme à mouvements croisés, selon des premier et deuxième axes respectivement parallèles aux lignes et aux colonnes de ladite matrice, ledit mécanisme étant relié à un organe de contact desdites sorties pouvant se déplacer parallèlement à un troisième axe orthogonal au plan défini par lesdits premier et deuxième axes.

En particulier, ledit mécanisme à mouvements croisés peut comporter deux montants parallèles, sur lesquels peut coulisser une barre transversale, le long de laquelle peut se déplacer un support pour ledit organe de contact.

De préférence, ledit quatrième équipage comporte une plaque électriquement conductrice, en contact avec les sorties respectives des organes de branchement, montée sur un support pouvant se déplacer parallèlement aux colonnes de ladite matrice, dont l'extrémité supérieure présente une rangée d'organes de contact avec lesdites sorties, chacun desdits organes pouvant se déplacer orthogonalement au plan dudit support.

En particulier, chacun desdits organes de contact peut être un vérin en liaison avec un cylindre, dans lequel peut se déplacer, parallèlement aux lignes de ladite matrice, un piston délimitant, dans ledit cylindre, un compartiment sous pression et un compartiment sans pression.

Avantageusement, lesdits deuxième et troisième équipages forment un seul équipage, associé à une matrice unique, utilisable soit pour le test de continuité, soit pour le test d'isolement.

De préférence, l'ensemble des supports et des équipages est maintenu sous vide ou sous atmosphère inerte.

En particulier, lesdits moyens de mesure peuvent comprendre un pont de mesure ohmmétrique, couplé à un générateur de haute tension stabilisée.

A titre d'état de la technique antérieure pouvant être considéré comme utile pour l'intelligence de la présente invention, on peut citer les documents FR-A-2483159 et US-A-4471298.

FR-A-2483159 concerne un banc d'essais de câblages électriques ou d'équipements électriques à grande densité de points de test, notamment pour des ensembles câblés de liaisons électriques ou d'équipements électriques d'aéronefs, comprenant au moins une platine portant une pluralité de jacks individuels munis d'orifices individuels géométriquement repérés sur la platine, chaque jack comportant, d'un côté de la platine, une lame de contact mobile normalement appliquée contre un contact fixe, ladite lame mobile étant individuellement reliée à un contact de fichier, et ledit contact fixe étant relié aux autres contacts fixes correspondants pour être, de préférence, mis à la terre. La platine est réalisée sous forme d'un module comprenant une pluralité d'orifices disposés en lignes et en rangs, ladite platine coopérant avec une seconde platine disposée parallèlement à elle, l'une desdites platines portant les différentes lames mobiles et l'autre portant une pluralité de barres métalliques rigides parallèles, de sorte qu'à chaque rang de lames correspond une barre s'étendant sur toute la longueur du rang, les extrémités desdites lames mobiles d'un rang s'appliquant au repos, avec une force élastique, contre la barre correspondante du rang, pour s'éloigner de ladite barre lorsqu'une fiche est enfoncée dans l'orifice correspondant pour repousser la lame mobile et établir un contact électrique avec elle.

Quant à lui, US-A-4471298 décrit un appareil pour tester automatiquement les cartes de circuits imprimés sur lesquels des points de test sont disposés à l'intersection de lignes et de colonnes. Cet appareil comporte deux barres disposées au-dessus d'une carte de circuit imprimé, parallèlement aux colonnes des points de test. Chaque barre comporte un jeu de contacts de test qui peuvent être amenés au contact des points de test, disposés le long d'une colonne. Les barres sont mobiles par rapport à la carte de circuit imprimé et peuvent être amenées séquentiellement au contact de n'importe quelle paire de colonnes de points de test. Des tensions de test sont appliquées séquentiellement aux paires choisies de contacts de test, ce qui permet de mesurer les caractéristiques électriques entre les paires de points de test. On met en oeuvre un microprocesseur pour contrôler la séquence de test et corréler les résultats.

Les figures du dessin annexé feront bien comprendre comment l'invention peut être réalisée. Sur ces figures, des références identiques désignent des éléments semblables.

La figure 1 est un schéma synoptique d'un système pour tester la continuité électrique et l'isolement des conducteurs d'une pièce de câblage.

La figure 2 illustre schématiquement un exemple de réalisation des moyens de liaison et des moyens de sélection du système selon l'invention.

La figure 3 est une vue schématique en perspective illustrant, plus particulièrement, les équipages constituant les moyens de sélection du système selon l'invention.

La figure 4 est une vue schématique en perspective, à plus grande échelle, d'un premier type d'équipage de la figure 3.

La figure 5 est une vue schématique en perspective, à plus grande échelle, d'un second type d'équipage de la figure 3.

La figure 6 est une vue de dessus de l'équipage de la figure 5.

La figure 7 est une vue de côté partielle de l'équipage de la figure 5.

Les figures 8 et 9 illustrent, respectivement, le principe du test de continuité et le principe du test d'isolement d'un conducteur électrique de la pièce de câblage.

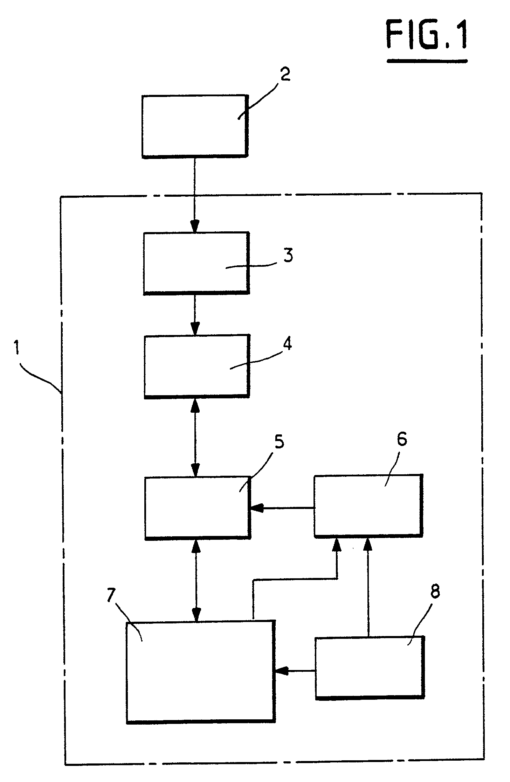

En se référant à la figure 1, un système 1 pour tester la continuité électrique et l'isolement des conducteurs électriques d'une pièce de câblage 2 comprend généralement :
- des moyens de liaison 3 avec chacun des conducteurs de la pièce de câblage 2,
- des moyens de sélection 4 de sorties déterminées des moyens de liaison 3,
- des moyens de mesure 5 d'une grandeur électrique, pouvant être appliquée auxdites sorties déterminées des moyens de liaison 3,
- des moyens 6 générateurs d'une grandeur électrique identique à celle mesurée ou différente de cette dernière, reliés auxdits moyens de mesure 5,
- des moyens 7 de pilotage du système 1 et d'analyse des tests, et
- une alimentation électrique générale 8.

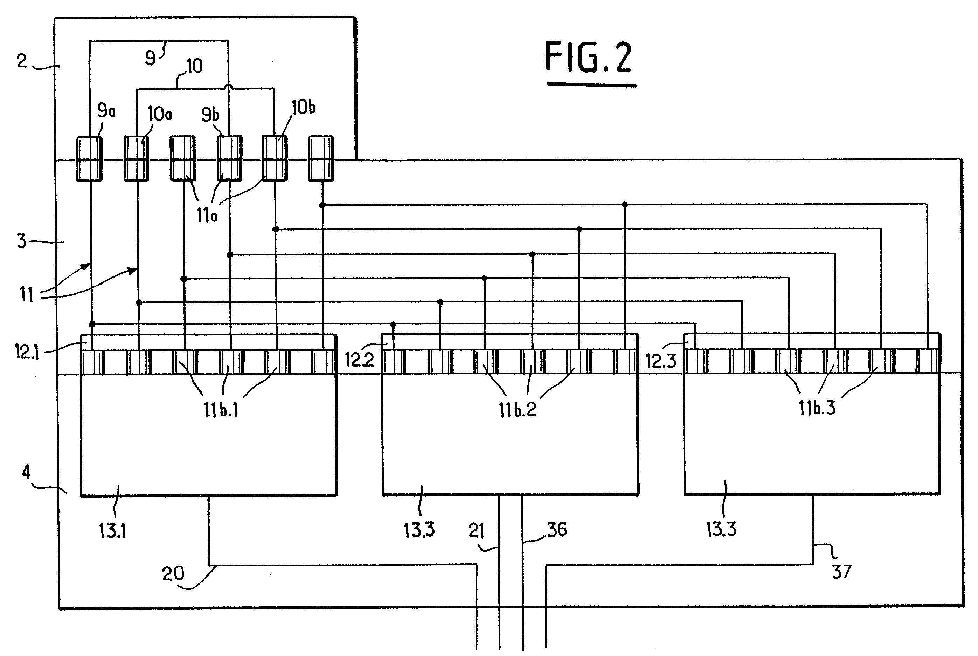

La figure 2 illustre, schématiquement et en plan, un exemple d'architecture des moyens de liaison 3 et des moyens de sélection 4 du système 1 selon l'invention. Sur cette figure, on a représenté deux conducteurs 9,10 de la pièce de câblage 2 (cette dernière en comportant bien entendu en réalité un grand nombre), chacun desdits conducteurs 9,10 comportant des premier 9a,10a et second 9b,10b éléments de connexion.

Les moyens de liaison 3 comprennent une pluralité d'organes de branchement 11 (une fois encore le nombre d'organes de branchement représenté est purement illustratif) , aux entrées 11a desquels peuvent être branchés les premier 9a,10a et second 9b,10b éléments de connexion de chacun des conducteurs 9,10, et dont les sorties 11b.1, 11b.2 et 11b.3, reliées en parallèle, sont agencées sur des supports respectifs 12.1, 12.2 et 12.3, et sont reliées aux moyens de sélection 4, décrits en détail par la suite.

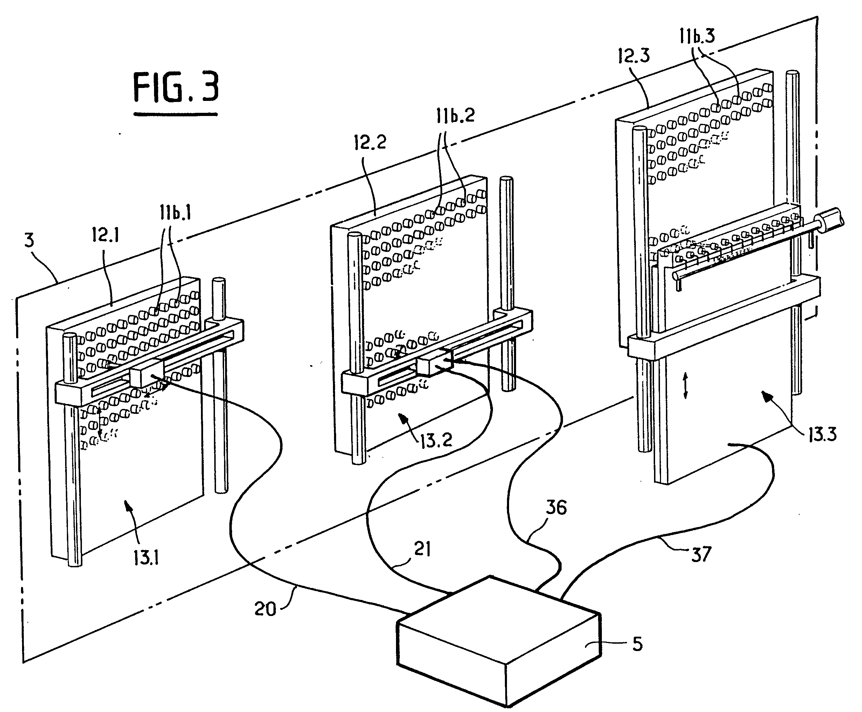

On voit mieux, sur la figure 3, l'agencement concret des moyens de liaison 3 et des moyens de sélection 4 notamment. Ainsi, dans cet exemple de réalisation pratique de l'invention, les sorties 11b,1, 11b.2 et 11b.3 des organes de branchement 11 sont regroupées, sur leurs supports respectifs 12.1, 12.2 et 12.3, sous forme de trois matrices de n lignes et p colonnes, et les moyens de sélection 4 comprennent trois équipages 13.1, 13.2 et 13.3, associés, chacun, à une matrice desdites sorties 11b,1, 11b.2 et 11b.3. L'ensemble des supports et des équipages est avantageusement maintenu sous vide ou sous atmosphère inerte, pour des raisons de fiabilité des mesures.

Plus particulièrement, les équipages 13.1 et 13.2 pour le test de continuité, dont les structures sont identiques, sont susceptibles de se déplacer le long des lignes et colonnes de la matrice correspondante de sorties 11b.1 et 11b.2.

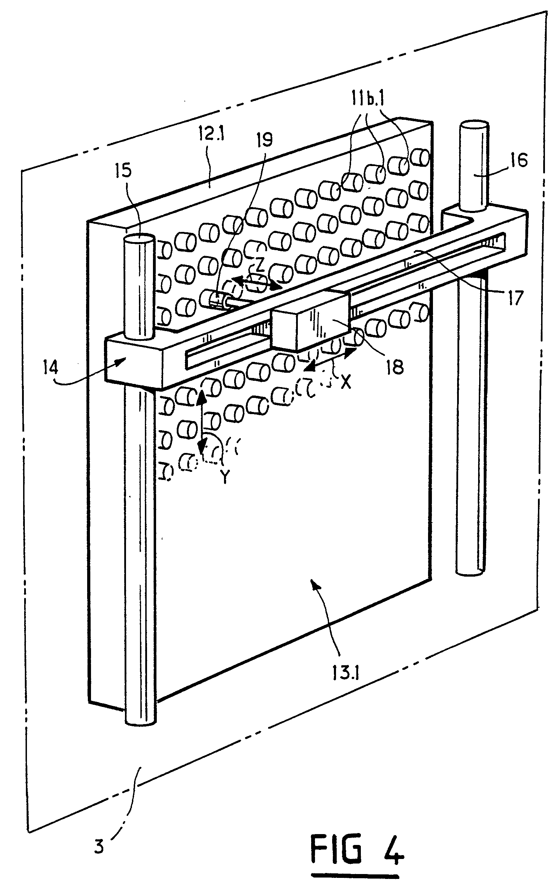

Comme on peut mieux le voir sur la figure 4, sur laquelle on a représenté, à plus grande échelle, l'équipage 13.1 (l'équipage 13.2 ayant une structure identique) , ce dernier comprend un mécanisme à mouvements croisés 14, déplaçable selon des axes X et Y respectivement parallèles aux lignes et aux colonnes de la matrice associée de sorties 11b.1. Le mécanisme à mouvements croisés 14, animé par des moyens moteurs non représentés, comporte deux montants 15,16 parallèles à l'axe Y (et disposés de part et d'autre, respectivement, du support 12.1), sur lesquels peut coulisser une barre transversale 17 parallèle à l'axe X, barre le long de laquelle peut se déplacer un support 18 pour un organe de contact 19 avec une desdites sorties 11b.1 de la matrice. L'organe de contact 19, qui peut être réalisé sous forme d'un vérin à commande pneumatique, électrique ou électro-mécanique, peut se déplacer parallèlement à un axe Z orthogonal au plan défini par les axes X et Y.

Par ailleurs, comme montré sur la figure 3, les équipages 13.1 et 13.2 sont reliés aux moyens de mesure 5 par les liaisons respectives 20 et 21.

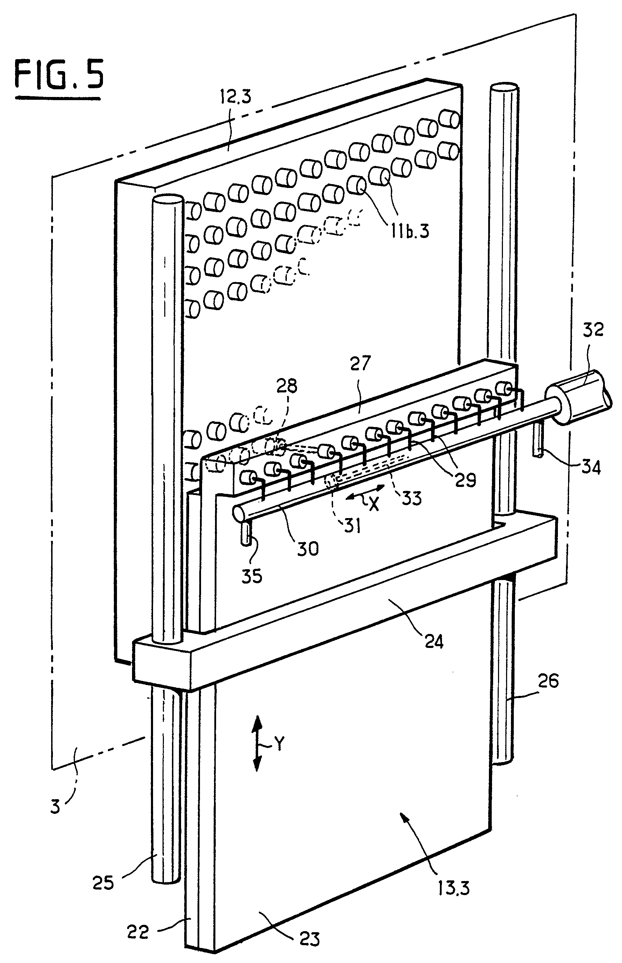

L'équipage 13.2 peut servir également pour le test d'isolement, en liaison avec l'équipage 13.3, de structure différente, que l'on décrira ci-après en référence aux figures 5, 6 et 7.

En se référant à la figure 5, l'équipage 13.3 comporte une plaque électriquement conductrice 22 en contact avec les sorties 11b.3 des organes de branchement 11, et montée sur un support 23 pouvant se déplacer parallèlement à l'axe Y défini précédemment (c'est-à-dire parallèlement aux colonnes de la matrice correspondante). Pour cela, le support 23 et la plaque conductrice 22 sont solidaires d'une barre transversale 24, parallèle à l'axe X, elle-même guidée sur des montants 25,26 parallèles à l'axe Y, l'ensemble étant animé par des moyens moteurs non représentés.

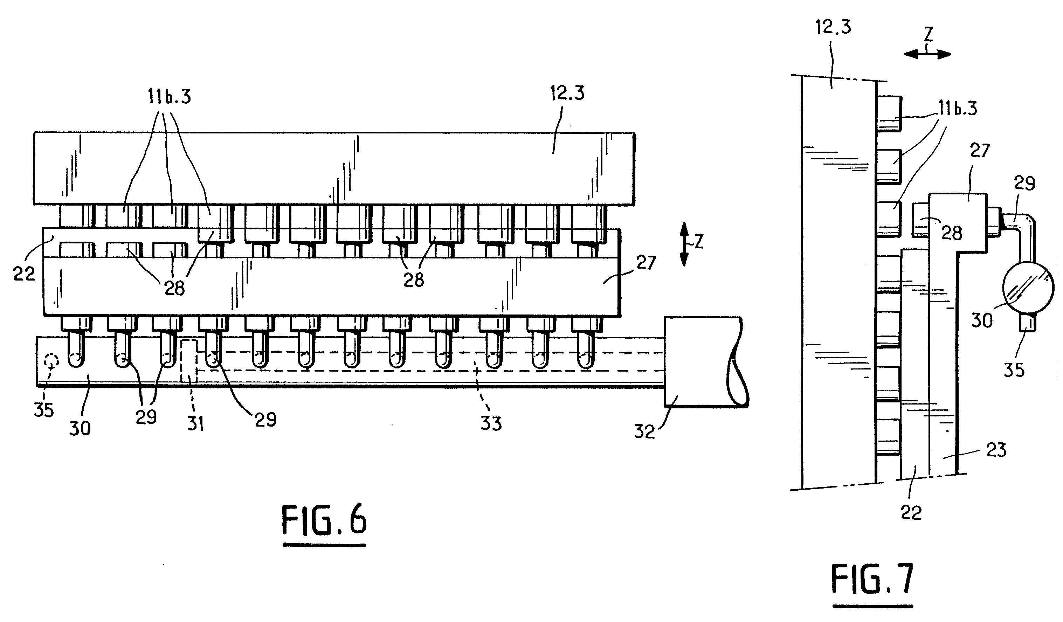

Par ailleurs, comme on le voit mieux sur les figures 6 et 7, l'extrémité supérieure 27 du support 23 présente une rangée d'organes de contact 28 avec les sorties 11b.3, s'étendant parallèlement à l'axe X (c'est-à-dire parallèlement à une ligne de la matrice). Chacun desdits organes de contact 28 est, de préférence, un vérin pneumatique, pouvant se déplacer parallèlement à l'axe Z tel que défini ci-dessus, en liaison, par un conduit 29, avec un cylindre 30, dans lequel peut se déplacer, parallèlement à l'axe X, un piston 31 sous l'action d'un moteur 32 auquel il est relié par une tige de piston 33. Le cylindre 30 est relié de plus à un conduit 34 de mise sous pression relié à une alimentation de fluide (non représentée) et à un conduit 35 de mise à l'air libre.

De plus, comme montré sur la figure 3, les équipages 13.2 et 13.3 sont reliés aux moyens de mesure 5 par les liaisons respectives 36 et 37.

Ainsi, le système selon l'invention utilise en fait trois modules de sélection (ou de commutation) :
- deux modules 13.1 et 13.2 pour les essais de continuité (point de départ, point d'arrivée),
- deux modules 13.2 et 13.3 pour les essais d'isolement (point de test et court-circuit des adresses inférieures).

Comme déjà indiqué, le module 13.2 est commun aux deux types d'essais.

Comme moyens de mesure 5, on peut utiliser un pont de mesure ohmmétrique (gamme de mesure de quelques milli-ohms à 500 mégohms), couplé à un générateur de haute tension stabilisée à gamme réglable pas à pas.

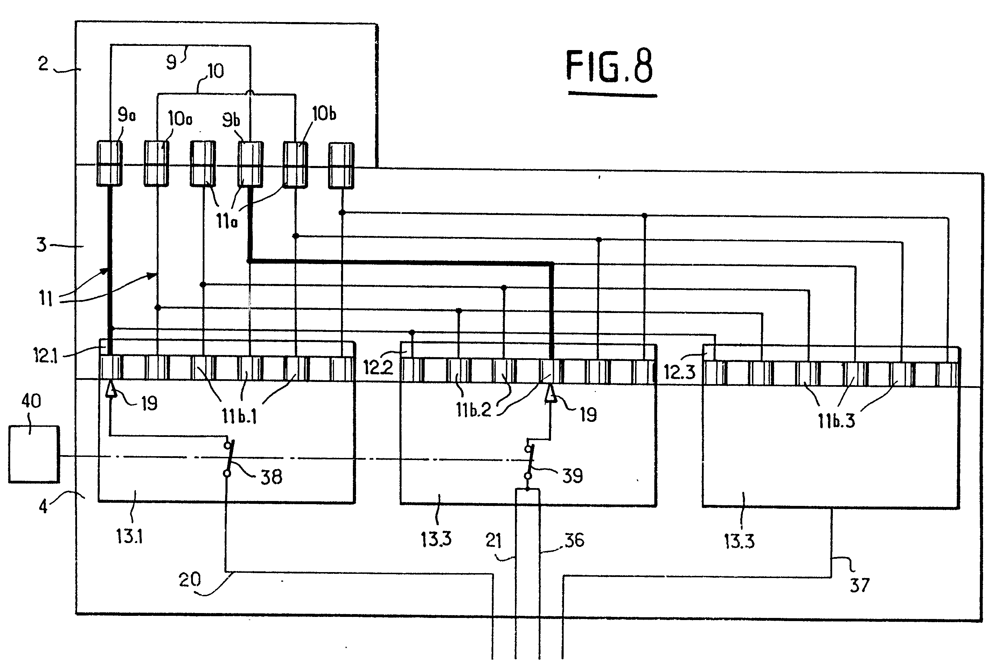

La figure 8 illustre le principe du test de continuité d'un conducteur électrique de la pièce de câblage, et cela en liaison avec la représentation de la figure 3.

Pour tester la continuité, par exemple, du conducteur 9, il convient de relier, par l'intermédiaire d'à chaque fois un organe de branchement 11, les premier 9a et second 9b éléments de connexion du conducteur 9 aux moyens de mesure 5, et donc aux moyens 6 générateurs d'une grandeur électrique (courant, tension). Pour cela, grâce aux moyens de pilotage 7, l'organe de contact 19 de l'équipage 13.1 est amené en contact, par déplacement du mécanisme à mouvements croisés 14 selon les axes X et Y et déplacement de l'organe de contact 19 selon l'axe Z, avec la sortie 11b.1 sur le support 12.1, correspondant à l'entrée 11a de l'organe de branchement 11 reliée au premier élément de connexion 9a du conducteur 9. De même, l'organe de contact 19 de l'équipage 13.2 est amené en contact, de la même façon, avec la sortie 11b.2 sur le support 12.2, correspondant à l'entrée 11a de l'organe de branchement 11 reliée au second élément de connexion 9b du conducteur 9.

Le circuit est fermé par actionnement des interrupteurs 38,39 au moyen de la commande 40, permettant ainsi de réaliser le test de continuité sur le conducteur à l'aide des moyens de mesure 5 (le module 13.3 est dans ce cas neutralisé).

L'essai d'isolement d'un conducteur est effectué par rapport aux autres conducteurs de la pièce de câblage. Toutefois, dans des buts d'économie et de rapidité d'exécution, la méthode suivante est utilisée, et cela est vrai pour la plupart des bancs de tests existants. Pour un ensemble de, par exemple, dix conducteurs, indépendants les uns des autres, un test est effectué sur le premier conducteur en reliant les neuf autres aux moyens de mesure. Si le test est positif (c'est-à-dire si l'isolement du premier conducteur est vérifié), on considère qu'il n'est plus nécessaire de vérifier si le deuxième conducteur est isolé du premier. Le deuxième conducteur sera donc testé par rapport aux huit conducteurs restants, le troisième par rapport aux sept autres, et, ainsi de suite, pour tous les conducteurs de la pièce de câblage.

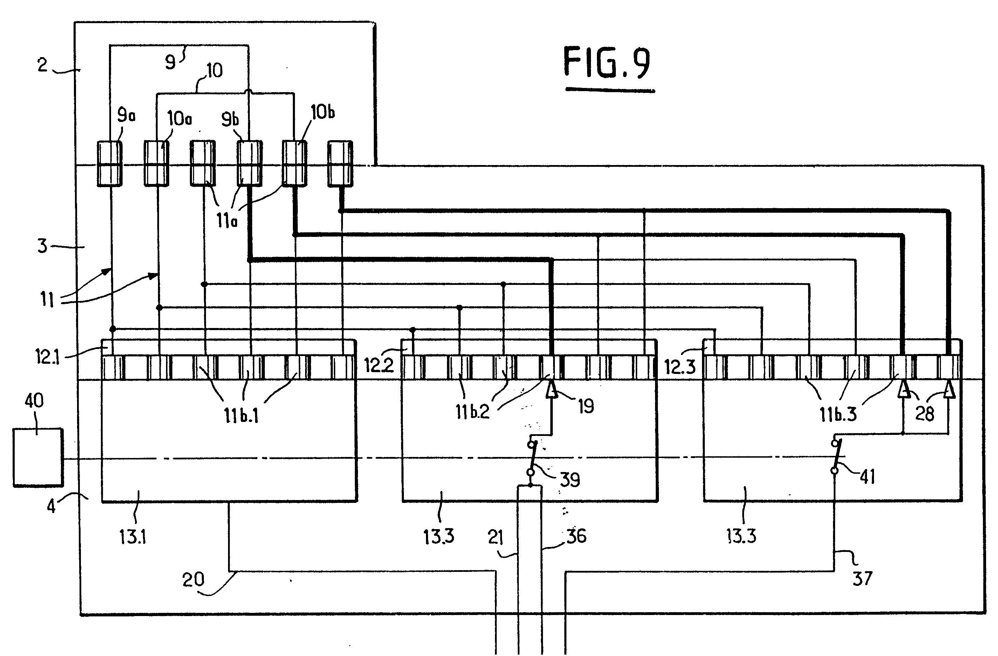

La figure 9 illustre le principe du test d'isolement d'un conducteur électrique de la pièce de câblage, et cela en liaison avec la représentation de la figure 3.

Pour tester l'isolement, par exemple, du conducteur 9, selon la méthode indiquée ci-dessus, il convient, d'une part, de relier le second élément de connexion 9b du conducteur 9 aux moyens de mesure 5. Pour cela, grâce aux moyens de pilotage 7, l'organe de contact 19 de l'équipage 13.2 est amené en contact avec la sortie 11b.2 sur le support 12.2, correspondant à l'entrée 11a de l'organe de branchement 11 reliée au second élément de connexion 9b du conducteur 9. D'autre part, toutes les sorties 11b.3 d'adresses inférieures au point de test doivent être court-circuitées. Cela est illustré sur la figure 9 et, de façon plus réaliste, sur la figure 3. Sur cette dernière figure, on voit que la plaque conductrice 22 de l'équipage 13.3 court-circuite toutes les sorties de la matrice disposées au-dessous de la ligne à laquelle appartient le point de test. Par ailleurs, toutes les sorties de cette ligne à droite du point de test sont en contact avec les organes 28 correspondants. Cela est obtenu par réglage de la position du piston 31 à l'aide du moteur 32, et mise sous pression desdits vérins 28 par amenée de fluide par le conduit 34.

Le circuit est fermé par actionnement des interrupteurs 39,41 au moyen de la commande 40, permettant ainsi de réaliser le test d'isolement sur le conducteur à l'aide des moyens de mesure 5 (le module 13.1 est dans ce cas neutralisé).

Par ailleurs, on doit noter que toutes les possibilités fonctionnelles complémentaires d'aide à l'opérateur et d'essais dynamiques, comme sur les systèmes usuels, peuvent être intégrées dans le système selon l'invention, à savoir :
- auto-contrôle complet,
- auto-programmation (apprentissage sur une pièce de câblage réputée bonne),
- langage naturel sur défaut,
- gammes programmables d'essais de continuité et d'isolement,
- sur défaut de continuité, recherche de l'inversion,
- recherche de tous les points et listage sur défaut d'isolement,
- mesure de résistance, de capacité électrique, de tension, de courant, continu et alternatif,
- mesure de diode,
- dialogue avec l'opérateur,
- alimentation programmable permettant les essais dynamiques.

Le tableau comparatif ci-dessous illustre, pour un banc de tests comportant 8400 points de tests, les avantages, concernant l'encombrement et le nombre de commandes, du système selon l'invention par rapport à un système usuel [les commandes du système de l'invention comprenant simplement des moteurs pas à pas pour les équipages, trois commandes de mise en contact (axe Z), et un relais (trois étages) de commutation de courant (tension)].

| | Système usuel | Système selon l'invention |
|---|---|---|
| Nombre de commandes | 174 | 11 |
| Volume (m³) | 4 | 0,5 |
| Poids (kg) | 600-700 | inférieur à 100 |

Le système selon l'invention présente donc une mobilité et une souplesse d'emploi plus grandes que les systèmes usuels, la simplification des commandes permet de faciliter la maintenance du système et le rend plus fiable, tandis que l'énergie nécessaire à son fonctionnement est nettement inférieure à celle nécessaire pour commander la multitude d'interrupteurs d'un système usuel.

## Revendications

1. Système (1) pour tester la continuité électrique et l'isolement des conducteurs électriques (9,10) d'une pièce de câblage, (2), munis chacun de premier et second éléments de connexion (9a,10a-9b,10b), du type comportant :
- des moyens de liaison (3) avec lesdits premier et second éléments de connexion de chacun desdits conducteurs, lesdits moyens de liaison comprenant une pluralité d'organes de branchement (11), aux entrées (lla) desquels sont aptes à être branchés les premier (9a,10a) et second (9b,10b) éléments de connexion de chacun desdits conducteurs (9,10) ;
- des moyens de mesure (5) d'une grandeur électrique, reliés à des sorties déterminées (11b.1, 11b.2, 11b.3) desdits organes de branchement (11) par l'intermédiaire de moyens (4) de sélection desdites sorties pour, d'une part, relier les premier et second éléments de connexion du conducteur testé auxdits moyens de mesure (5), de façon à tester la continuité électrique dudit conducteur et, d'autre part, relier ledit conducteur testé à au moins certains autres conducteurs de la pièce de câblage, de façon à tester l'isolement dudit conducteur par rapport auxdits autres conducteurs ;
- des moyens (6) générateurs d'une grandeur électrique identique à celle mesurée ou différente de cette dernière ; et
- des moyens (7) de pilotage du système et d'analyse des tests,
caractérisé en ce que les sorties (11b.1, 11b.2, 11b.3) desdits organes de branchement sont agencées, sur un support (12.1, 12.2, 12.3), sous forme d'une matrice de n lignes et p colonnes, et en ce que lesdits moyens de sélection (4) comprennent, d'une part pour le test de continuité, des premier (13.1) et deuxième (13.2) équipages, susceptibles de se déplacer le long des lignes et colonnes de ladite matrice, pour relier auxdits moyens de mesure (5) les deux sorties desdits organes de branchement, correspondant aux premier et second éléments de connexion du conducteur testé, et d'autre part pour le test d'isolement, un troisième équipage identique au second (13.2), susceptible de se déplacer le long des lignes et colonnes de ladite matrice, pour relier auxdits moyens de mesure (5) une sortie desdits organes de branchement, correspondant à un élément de connexion du conducteur testé, et un quatrième équipage (13.3) pour relier au moins certaines autres sorties desdits organes de branchement auxdits moyens de mesure (5).

2. Système selon la revendication 1,
caractérisé en ce que lesdits premier, deuxième, troisième et quatrième équipages sont associés, chacun, à une matrice de n lignes et p colonnes desdites sorties desdits organes de branchement, les sorties correspondantes desdites matrices étant reliées en parallèle, et en ce que lesdits premier, deuxième et troisième équipages comprennent, chacun, un mécanisme à mouvements croisés (14), selon des premier et deuxième axes respectivement parallèles aux lignes et aux colonnes de ladite matrice, ledit mécanisme (14) étant relié à un organe de contact (19) desdites sorties pouvant se déplacer parallèlement à un troisième axe orthogonal au plan défini par lesdits premier et deuxième axes.

3. Système selon la revendication 2,
caractérisé en ce que ledit mécanisme à mouvements croisés (14) comporte deux montants (15,16) parallèles, sur lesquels peut coulisser une barre transversale (17), le long de laquelle peut se déplacer un support (18) pour ledit organe de contact (19).

4. Système selon l'une quelconque des revendications 2 ou 3,
caractérisé en ce que ledit quatrième équipage (13.3) comporte une plaque électriquement conductrice (22), en contact avec les sorties respectives des organes de branchement, montée sur un support (23) pouvant se déplacer parallèlement aux colonnes de ladite matrice, dont l'extrémité supérieure (27) présente une rangée d'organes de contact (28) avec lesdites sorties, chacun desdits organes (28) pouvant se déplacer orthogonalement au plan dudit support (23).

5. Système selon la revendication 4,
caractérisé en ce que chacun desdits organes de contact est un vérin (28) en liaison avec un cylindre (30), dans lequel peut se déplacer, parallèlement aux lignes de ladite matrice, un piston (31) délimitant, dans ledit cylindre (30), un compartiment sous pression et un compartiment sans pression.

6. Système selon l'une quelconque des revendications 1 à 5,
caractérisé en ce que lesdits deuxième et troisième équipages forment un seul équipage (13.2), associé à une matrice unique, utilisable soit pour le test de continuité, soit pour le test d'isolement.

7. Système selon l'une quelconque des revendications 1 à 6,
caractérisé en ce que l'ensemble des supports (12.1, 12.2, 12.3) et des équipages (13,1, 13.2, 13.3) est maintenu sous vide ou sous atmosphère inerte.

8. Système selon l'une quelconque des revendications 1 à 7,
caractérisé en ce que lesdits moyens de mesure (5) comprennent un pont de mesure ohmmétrique, couplé à un générateur de haute tension stabilisée.

## Patentansprüche

1. System (1) zum Testen des elektrischen Durchgangs und der Isolation von elektrischen Leitern (9, 10) eines Verkabelungsabschnittes (2), jeder versehen mit ersten und zweiten Verbindungselementen (9a, 10a, 9b, 10b) der Art, das folgendes umfaßt:
- Verbindungsmittel (3) zur Verbindung mit den ersten und den zweiten Verbindungselementen jedes Leiters, wobei die Verbindungsmittel eine Vielzahl von Anschlußorganen (11) umfassen, an deren Eingängen (11a) die ersten (9a, 10a) und zweiten (9b, 10b) Verbindungselemente jedes Leiters (9, 10) angeschlossen werden können;
- Mittel (5) zur Messung einer elektrischen Größe, die an bestimmte Ausgänge (11b.1, 11b.2, 11b.3) der Anschlußorgane (11) über dazwischengeschaltete Mittel (4) zur Auswahl der Ausgänge angeschlossen sind, um einerseits die ersten und zweiten Verbindungselemente eines geprüften Leiters mit den Mitteln zur Messung (5) für die Prüfung des elektrischen Durchgangs des Leiters zu verbinden und andererseits den Leiter wenigstens mit bestimmten anderen Leitern des Verkabelungsabschnittes zu verbinden, um die Isolation des Leiters im Vergleich zu den anderen Leitern zu testen;
- Mittel (6) zur Erzeugung einer elektrischen Größe, die identisch mit der gemessenen oder verschieden zu dieser ist; und
- Mittel (7) zur Steuerung des Systems und zur Analyse der Tests,
dadurch gekennzeichnet, daß die Ausgänge (11b.1, 11b.2, 11b.3) der Anschlußorgane auf einem Träger (12.1, 12.2, 12.3) in Gestalt einer Matrix mit n Zeilen und p Spalten angeordnet sind und daß die Mittel zur Auswahl (4) einerseits für den Durchgangstest erste (13.1) und zweite (13.2) Einrichtungen, die imstande sind, sich entlang der Zeilen und Spalten der Matrix zu bewegen, um an die Mittel zur Messung (5) die zwei Ausgänge der Anschlußorgane, die mit den ersten und zweiten Verbindungselementen des geprüften Leiters verbunden sind, anzuschließen, und andererseits für den Isolationstest eine dritte, zur zweiten Einrichtung identische Einrichtung (13.2), die imstande ist, sich entlang der Zeilen und Spalten der Matrix zu bewegen, um an die Mittel zur Messung (5) einen Ausgang der Anschlußorgane, der mit einem Verbindungselement des geprüften Leiters verbunden ist, anzuschließen, sowie eine vierte Einrichtung (13.3) umfassen, um wenigstens bestimmte andere Ausgänge der Anschlußorgane mit den Mitteln zur Messung (5) zu verbinden.

2. System nach Anspruch 1, dadurch gekennzeichnet, daß die ersten, zweiten, dritten und vierten Einrichtungen jeweils mit einer Matrix mit n Zeilen und p Spalten der Ausgänge der Anschlußelemente verbunden sind, wobei die entsprechenden Ausgänge der Matrizen parallel verbunden sind und dadurch, daß die ersten, zweiten und dritten Einrichtungen jeweils einen Mechanismus für gekreuzte Bewegungen (14) gemäß ersten und zweiten Achsen, die jeweils parallel zu den Zeilen und Spalten der Matrix verlaufen, umfassen, wobei der Mechanismus (14) an ein Organ (19) zur Kontaktierung der Ausgänge angeschlossen ist, das parallel zu einer dritten Achse, die orthogonal zu einer Ebene verläuft, die durch die erste und zweite Achse definiert wird, verschiebbar ist.

3. System nach Anspruch 2, dadurch gekennzeichnet, daß der Mechanismus für die gekreuzten Bewegungen (14) zwei parallele Stützen (15, 16) umfaßt, auf welchen ein Querbalken (17), an dem entlang eine Aufnahme (18) für die Kontaktorgane (19) verschiebbar ist, gleiten kann.

4. System nach einem der Ansprüche 2 oder 3, dadurch gekennzeichnet, daß die vierte Einrichtung (13.3) eine elektrisch leitfähige Platte (22) umfaßt, die in Kontakt mit den jeweiligen Ausgängen der Anschlußorgane ist und auf einen Träger (23) montiert ist, der sich parallel zu den Spalten der Matrix verschieben läßt, dessen oberes äußeres Ende (27) eine Reihe von Organen zur Kontaktierung (28) der Ausgänge aufweist, wobei jedes der Organe (28) orthogonal zur Ebene des Trägers (23) bewegbar ist.

5. System nach Anspruch 4, dadurch gekennzeichnet, daß jedes der Kontaktorgane ein Stellglied (28) in Verbindung mit einem Zylinder (30) ist, in dem sich parallel zu den Zeilen der Matrix ein Kolben (31) bewegen läßt, der im Zylinder (30) einen Bereich mit Druck und einen Bereich ohne Druck trennt.

6. System nach einem der Ansprüche 1 bis 5, dadurch gekennzeichnet, daß die zweite und dritte Einrichtung eine einzige Einrichtung (13.2) bilden, die zu einer einzigen Matrix verbunden ist und die sowohl für den Durchgangstest als auch für den Isolationstest einsetzbar ist.

7. System nach einem der Ansprüche 1 bis 6, dadurch gekennzeichnet, daß die Gesamtheit der Träger (12.1, 12.2, 12.3) und der Einrichtungen (13.1, 13.2, 13.3) unter Vakuum oder in inerter Atmosphäre gehalten sind.

8. System nach einem der Ansprüche 1 bis 7, dadurch gekennzeichnet, daß die Mittel zur Messung (5) eine Ohmsche Meßbrücke umfassen, die mit einem stabilisierten Hochspannungsgenerator gekoppelt ist.

## Claims

1. System (1) for testing the electrical continuity and the insulation of the electrical conductors (9, 10) of a wiring harness (2), each equipped with first and second connection elements (9a, 10a, 9b, 10b), of the type including:
- means (3) of linking to the said first and second connection elements of each of the said conductors, the said linkage means comprising a plurality of connection members (11), to the inputs (11a) of which connection members the first (9a, 10a) and second (9b, 10b) connection elements of each of the said conductors (9, 10) are capable of being connected;
- means (5) of measuring an electrical quantity, these means being connected to defined outputs (11b.1, 11b.2, 11b.3) of the said connection members (11) via means (4) of selecting the said outputs in order, on the one hand, to connect the first and second connection elements of the tested conductor to the said measurement means (5), so as to test the electrical continuity of the said conductor and, on the other hand, to connect the said tested conductor to at least certain other conductors of the wiring harness so as to test the insulation of the said conductor with respect to the said other conductors;
- means (6) of generating an electrical quantity identical to that measured or different from the latter; and
- means (7) of controlling the system and of analysing the tests,
characterized in that the outputs (11b.1, 11b.2, 11b.3) of the said connection members are arranged on a support (12.1, 12.2, 12.3), in the form of a matrix of n rows and p columns, and in that the said selection means (4) comprise, on the one hand for the continuity test, first (13.1) and second (13.2) contrivances, capable of moving along the rows and columns of the said matrix, for connecting the two outputs of the said connection members, corresponding to the first and second connection elements of the tested conductor, to the said measurement means (5), and, on the other hand for the insulation test, a third contrivance identical to the second (13.2), capable of moving along the rows and columns of the said matrix, for connecting an output of the said connection members, corresponding to a connection element of the tested conductor, to the said measurement means (5) and a fourth contrivance (13.3) for connecting at least certain other outputs of the said connection members to the said measurement means (5).

2. System according to Claim 1, characterized in that the said first, second, third and fourth contrivances are each associated with a matrix of n rows and p columns of the said outputs of the said connection members, the corresponding outputs of the said matrices being connected in parallel, and in that the said first, second and third contrivances each comprise a cross-movement mechanism (14), for movement along the first and second axes respectively parallel to the rows and to the columns of the said matrix, the said mechanism (14) being connected to a member (19) for contacting the said outputs which can move parallel to a third axis orthogonal to the plane defined by the said first and second axes.

3. System according to Claim 2, characterized in that the said cross-movement mechanism (14) includes two parallel uprights (15, 16) on which a transverse bar (17) can slide, along which bar a support (18) for the said contacting member (19) can move.

4. System according to either of Claims 2 and 3, characterized in that the said fourth contrivance (13.3) includes an electrically conducting plate (22), in contact with the respective outputs of the connection members, this plate being mounted on a support (23) which can move parallel to the columns of the said matrix, the upper end (27) of which has a row of members (28) for contacting the said outputs, each of the said members (28) being able to move orthogonally to the plane of the said support (23).

5. System according to Claim 4, characterized in that each of the said contacting members is an actuator (28) in conjunction with a cylinder (30) in which a piston (31) can move parallel to the rows of the said matrix, this piston delimiting, in the said cylinder (30), a pressurized compartment and a non-pressurized compartment.

6. System according to any one of Claims 1 to 5, characterized in that the said second and third contrivances make up a single contrivance (13.2), associated with a single matrix, which can be used either for the continuity test or for the insulation test.

7. System according to any one of Claims 1 to 6, characterized in that the set of supports (12.1, 12.2, 12.3) and of the contrivances (13.1, 13.2, 13.3) is maintained under vacuum or in an inert atmosphere.

8. System according to any one of Claims 1 to 7, characterized in that the said measurement means (5) comprise an ohmmeter test bridge coupled to a stabilized high-voltage generator.
